# EUROPÄISCHE PATENTANMELDUNG

(11) **EP 1 229 774 A2**
(43) Veröffentlichungstag der Anmeldung: **07.08.2002**
(21) Anmeldenummer: 02000696.1
(22) Anmeldetag: 11.01.2002
(51) Int. Cl.: H05K 7/14

(54) **Dreiteiliger Baugruppeneinschub**

(30) Priorität: 06.02.2001 DE 10105604
(71) Anmelder: Fujitsu Siemens Computers GmbH, 81739 München (DE)
(72) Erfinder: Fietz, Ralf-Peter, 33104 Paderborn (DE)
(74) Vertreter: Epping Hermann & Fischer

(57) **Zusammenfassung**

Die Erfindung betrifft einen dreiteiligen Baugruppeneinschub, bei dem die drei Baugruppen (1, 2 und 3) über ein Trägermittel (5) miteinander verbunden sind. Um ein Austauschen während des Betriebes zu ermöglichen (hot plug) sind erfindungsgemäß bei zumindest zwei Baugruppen über das Trägermittel (5) vorspringenden Kanten (6) ausgebildet, durch welche ein geführtes Einstecken bzw. Ziehen der Baugruppeneinschübe in Standardkartenführungen ermöglicht wird.

## Beschreibung

Die Erfindung betrifft einen dreiteiligen Baugruppeneinschub, bei dem die drei Baugruppben über ein Trägermittel miteinander verbunden sind.

Ein derartiger Baugruppeneinschub ist z. B. von der Firma Mylex bekannt. Der Baugruppeneinschub besteht aus einem mittig angeordneten Controller und einem davor sowie dahinter geschalteten Adapter. Sowohl der Controller als auch die Adapter sind von der selben Breite und auf einem Blechträger zur Stabilisierung montiert. Der Blechträger ist U-förmig gebogen und nimmt vollkommen zwischen seinen beiden Schenkeln den Controller und die zwei Adapter auf.

Bei diesem Stand der Technik stellt sich ein Problem beim Wechseln des dreiteiligen Baugruppeneinschubens während des Betriebes der Rechnereinheit (hot plug). In der Regel werden derartige Controllereinschübe in Speichersubsystemen verwendet.

Ein auf dem in Steckrichtung liegenden vorderen Adapter befindlicher Stecker wird beim Einstecken in sein Gegenstück auf der Rückwand des Rechnersystems gesteckt. Um einen Wechsel während des Betriebes des Rechnersystems durchführen zu können, muß der Baugruppeneinschub in Standardführungen geführt eingesteckt bzw. gezogen werden können. Der von der Firma Mylex bekannte Baugruppeneinschub erlaubt keine Führung und ist daher für einen hot plug Wechsel nicht geeignet.

Der Erfindung liegt daher die Aufgabe zugrunde, den gattungsgemäßen dreiteiligungen Baugruppeneinschub so weiter zu entwickeln, daß ein Wechsel des Baugruppeneinschubes während des Betriebens (hot plug) ohne die Gefahr von Kurzschlüssen möglich ist.

Erfindungsgemäß wird diese Aufgabe dadurch gelöst, daß zumindest zwei Baugruppen über das Trägermittel vorspringende Kanten aufweisen, welche ein geführtes Einstecken des Baugruppeneinschubes erlauben.

Die über das Trägermittel vorspringenden Kanten der beiden Baugruppen führen den gesamten Baugruppeneinschub in den Standardkartenführungen sowohl beim Einstecken wie auch beim Herausziehen des Baugruppeneinschubes. Somit ist zum einen die Kontaktierung des Gegensteckers auf der Rückwand durch den Stecker auf dem vorderen Adapter wesentlich vereinfacht und zum anderen die Gefahr von Kurzschlüssen während der Montage bzw. Demontage nahezu ausgeschlossen.

Vorteilhafter Weise sind an den äußeren beiden Baugruppen die vorspringenden Kanten vorgesehen, da hierdurch eine bessere Führung als wie über vorspringende Kanten an zwei nebeneinander liegenden Baugruppen erzielt wird.

Das Trägermittel ist vorzugsweise als formsteifes Trägerblech mit großen Öffnungen ausgebildet.

Die Formsteifigkeit des Trägerbleches gewährleistet, daß die Steckverbindungen zwischen den einzelnen Baugruppen nicht durch mechanische Kräfte belastet werden. Durch die großen Öffnungen im Trägerblech wird erzielt, daß die Baugruppen uneingeschränkt ihre Wärme an die Umgebungsluft abgeben können.

Gemäß einer bevorzugten Ausführungsform ist zusätzlich zwischen Trägerblech und der mittleren Baugruppe ein Kühlblech angeordnet.

In der Regel ist die mittlere Baugruppe ein Controller und sind die äußeren Baugruppen Adapter, so daß über das Kühlblech zusätzlich die Wärmeabgabe des Controllers gesteigert werden kann.

Die Adapter sind vorzugsweise beidseits des Controller ausgebildet, um verschiedene Standardcontroller verwenden zu können, ohne das Trägermittel jeweils an die Breite des Standardcontrollers anpassen zu müssen.

Vorteilhafterweise ist eine Kabelverbindung zwischen den Baugruppen, meist zwischen den Adaptern, definiert zwischen dem Trägermittel und den Baugruppen geführt. Hierdurch wird eine einfache Montage erzielt und zusätzlicher Aufwand für die Kabelverlegung vermieden.

Zur Gewährleistung der elektromagnetischen Abschirmung ist gemäß einer weiteren bevorzugten Ausführungsform mit der in Steckrichtung zuletzt angeordneten Baugruppe eine Blende verbunden, welche nach dem Einstecken über seitliche Kontaktelemente eine leitende Verbindung zum aufnehmenden Gehäuse herstellt.

Günstigerweise ist der Baugruppeneinschub auch über eine Schraube an der Blende im Gehäuse verriegelbar.

Weitere vorteilhafte Ausgestaltungen der Erfindung sind in der folgenden Figurenbeschreibung offenbart.

Anhand eines in den Zeichnungen dargestellten Ausführungsbeispieles wird die Erfindung nun näher erläutert.

In den Zeichnungen zeigen:
Figur 1 eine Schrägansicht eines dreiteiligen Baugruppeneinschubes,
Figur 2 den dreiteiligen Baugruppeneinschub in Seitenansicht,
Figur 3 eine Schrägansicht des Trägermittels,
Figur 4 in Schrägansicht eine Explosionsdarstellung des Trägermittel und der mittleren Baugruppe und
Figur 5 die Ansicht gemäß Figur 4 mit einer zweilagigen mittleren Baugruppe.

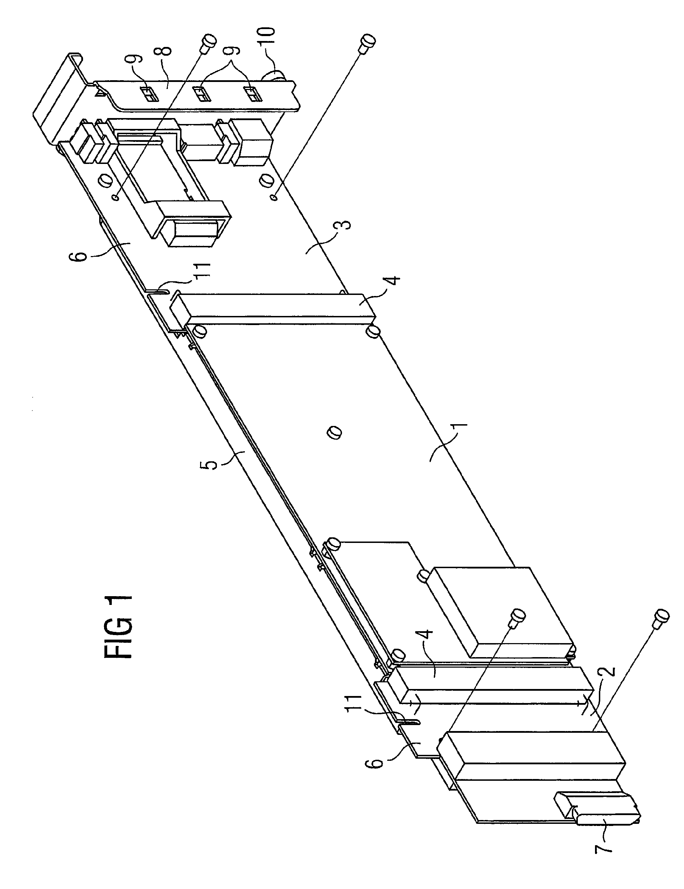

Figur 1 zeigt eine Schrägansicht des dreiteiligen Baugruppeneinschubes. Dieser weist als mittlere Baugruppe 1 einen Controller auf, welcher beidseitig mit äußeren Baugruppen 2 und 3 über Steckverbindungen 4 kontaktiert ist. Der Controller 1 wird in der Regel als Standardteil gekauft. Die äußeren Baugruppen 2 und 3 sind Adapter, welche die Einsetzbarkeit von Standardcontrollern ermöglichen.

Da die Steckverbindungen 4 nicht mit mechanischen Kräften belastet werden dürfen, sind die Baugruppen 1, 2 und 3 über ein Trägermittel 5 miteinander verbunden.

Das Trägermittel 5 ist ein formsteifes Trägerblech, mit welchem alle drei Baugruppen 1, 2 und 3 verschraubt sind. Die beiden Adapter 2 und 3 weisen über die Oberseite des Trägermittels 5 vorspringende Kanten 6 auf, welche ein geführtes Einstecken des Baugruppeneinschubes in Standardkantenführungen erlauben. An dem in Steckrichtung vorderen Adapater 2 ist ein Stecker 7 angeordnet, welcher beim Einstecken des Baugruppeneinschubes einen Gegenstecker auf einer Rückwand eines Servers oder einer Computereinheit kontaktiert.

Der in Steckrichtung hintere Adapater 3 ist mit einer Blende 8 versehen, welche die elektromagnetische Abschirmung gewährleistet. Dazu ist die Blende A seitlich mit Kontaktelementen 9 ausgestattet, welche das Gehäuse, in das der Baugruppeneinschub eingesteckt wird, kontaktieren.

Zur Sicherung des Baugruppeneinschubes im Gehäuse ist an der Blende 8 desweiteren eine gerändelte Schraube 10 vorgesehen, durch welche der Baugruppeneinschub am Gehäuse festgelegt werden kann.

Das Trägermittel 5 ist in demjenigen Bereich, in dem es den Controller 1 aufnimmt U-förmig ausgebildet.

Die beiden Adapater 2 und 3 sind über ein Kabel miteinander verbunden, wobei dieses zwischen dem Trägermittel 5 und dem Baugruppen 1 bis 3 definiert geführt aufgenommen ist.

Hierdurch erleichtert sich zum einen die Montage, zum anderen ist kein zusätzlicher Aufwand für die Kabelverlegung notwendig. An den Adaptern sind hierzu Schlitze 11 ausgebildet, durch welche die Kabel in den Zwischenraum zwischen Trägermittel 5 und den Baugruppen 1 bis 3 geführt werden können.

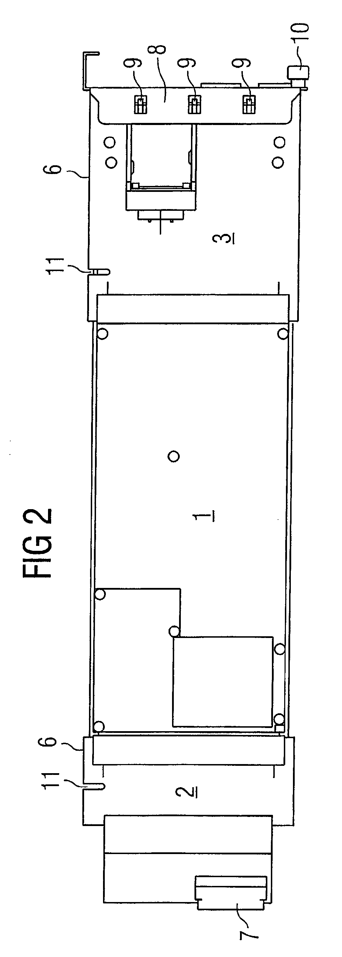

Figur 2 zeigt den kompletten Baugruppeneinschub gemäß Figur 1 in der Seitenansicht. In Figur 2 ist gut zu sehen, daß die Adapter 2 und 3 wesentlich breiter wie der Controller 1 ausgeführt sind. Auch weisen die Adapter 2 und 3, die nach oben über den Umriß des Trägermittels 5 vorspringenden Kanten 6 auf, durch welche ein geführtes Einstecken der Einschubbaugruppe in normalen standardisierten Kartenführungen gewährleistet ist.

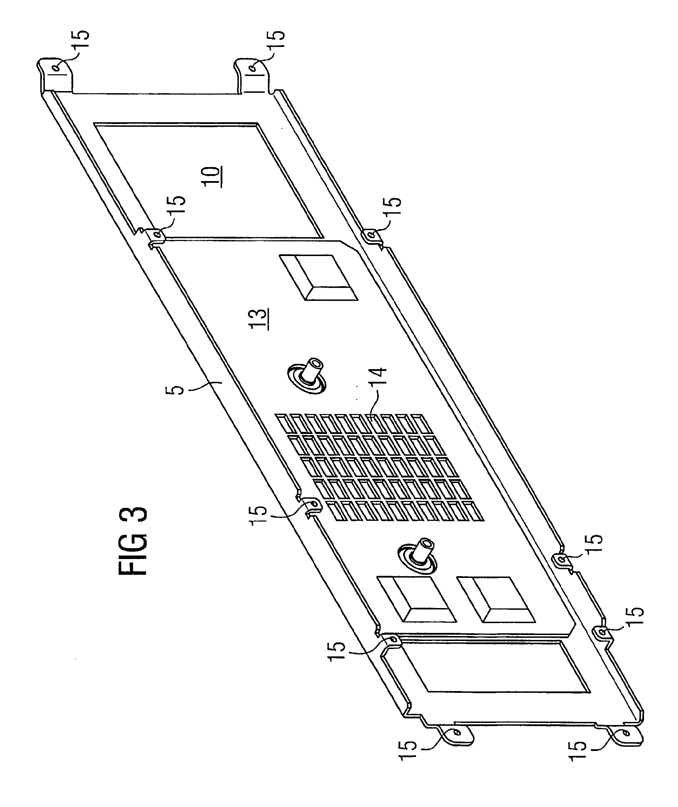

Figur 3 zeigt in Schrägansicht das Trägermittel 5. Diese ist, wie bereits zu Figur 1 erwähnt, als formsteifes Trägerblech ausgeführt und mit großen Öffnungen 10 versehen, so daß eine gute Wärmeabstrahlung der Baugruppen gewährleistet ist.

Im Mittelbereich, in dem der Controller 1 montiert wird, ist zusätzlich ein Kühlblech 13 mit einem Kühlgitter 14 vorgesehen, welches zu einer gesteigerten Kühlung des Controllers beiträgt.

Das Trägermittel 5 ist mit einer Reihe von Schraubaugen 15 versehen, an welchen die Baugruppen 1 bis 3 festgelegt werden.

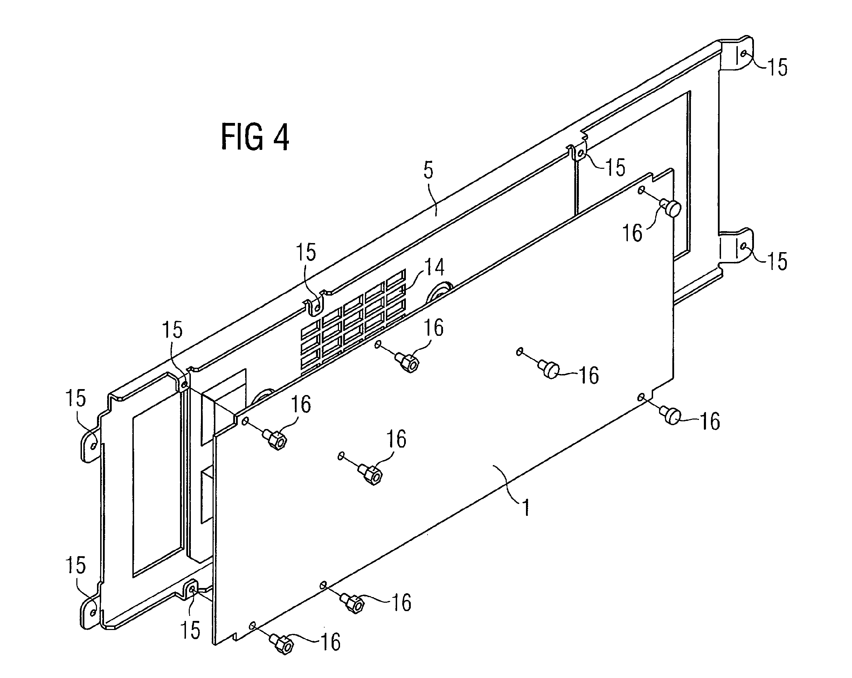

Figur 4 zeigt, wie an das Trägermittel 5 über Schrauben 16 der Controller 1 angeschraubt wird.

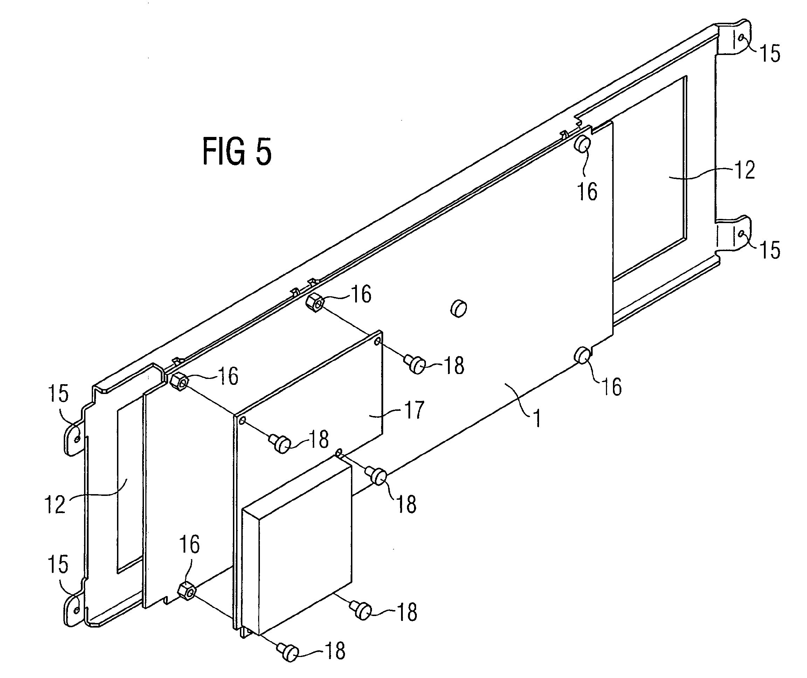

In Figur 5 ist die Ansicht gemäß Figur 4 dargestellt, wobei der Controller 1 bereits mit dem Trägermittel 5 verschraubt ist und lediglich eine weitere Controllerkomponente 17 über weitere Schrauben 18 doppellagig über Abstandhalter auf den Controller 1 aufgeschraubt wird.

Dadurch, daß der Controller 1 wesentlich schmäler als die Adapter 2 und 3 ausgeführt ist, und der komplette Baugruppeneinschub nur über die Adapter 2 und 3 geführt wird, ist es möglich, daß der Controller 1 in seiner Größe variieren kann und somit verschiedene Standardcontroller eingesetzt werden können. Lediglich die Anschraubaugen sind auf die eingesetzten Controller einzustimmen.

### Bezugszeichenliste

- 1: Mittlere Baugruppe (Controller)
- 2: Äußere Baugruppe (Adapter)
- 3: Äußere Baugruppe (Adapter)
- 4: Steckverbindung
- 5: Trägermittel
- 6: Vorspringende Kanten
- 7: Stecker
- 8: Blende
- 9: Kontaktelemente
- 10: Schrauben
- 11: Schlitze
- 12: Große Öffnungen
- 13: Kühlblech
- 14: Kühlgitter
- 15: Anschraubaugen
- 16: Schrauben
- 17: Controllerkomponente
- 18: Schrauben

## Patentansprüche

1. Dreiteiliger Baugruppeneinschub, bei dem die drei Baugruppen (1, 2, 3) über ein Trägermittel (5) miteinander verbunden sind,
**dadurch gekennzeichnet, daß**
zumindest zwei Baugruppen (2, 3) über das Trägermittel (5) vorspringende Kanten (6) aufweisen, welche ein geführtes Einstecken des Baugruppeneinschubes erlauben.

2. Dreiteiliger Baugruppeneinschub nach Anspruch 1,
**dadurch gekennzeichnet, daß**
die äußeren beiden Baugruppen (2, 3) die vorspringenden Kanten (6) aufweisen.

3. Dreiteiliger Baugruppeneinschub nach Anspruch 1 oder 2,
**dadurch gekennzeichnet, daß**
das Trägermittel (5) als formsteifes Trägerblech ausgebildet ist.

4. Controllereinschub nach einem der Ansprüche 1 bis 3,
**dadurch gekennzeichnet, daß**
zwischen dem Trägermittel (5) und der mittleren Baugruppe (1) ein Kühlblech (13) vorgesehen ist.

5. Dreiteiliger Baugruppeneinschub nach einem der Ansprüche 1 bis 4,
**dadurch gekennzeichnet, daß**
die äußeren beiden Baugruppen (2, 3) Adapter und die mittlere Baugruppe (1) ein Controller ist.

6. Dreiteiliger Baugruppeneinschub nach Anspruch 5,
**dadurch gekennzeichnet, daß**
die Adapter (2, 3) breiter als der Controller (1) ausgebildet sind.

7. Dreiteiliger Baugruppeneinschub nach einem der Ansprüche 1 bis 6,
**dadurch gekennzeichnet, daß**
eine Kabelverbindung zwischen den äußeren beiden Baugruppen definiert zwischen Trägermittel (5) den Baugruppen (1 bis 3) verlegt ist.

8. Dreiteiliger Baugruppeneinschub nach einem der Ansprüche 1 bis 7,
**dadurch gekennzeichnet, daß**
mit der in Steckrichtung hinteren Baugruppe eine Blende (8) verbunden ist, die nach dem Einstecken des Baugruppeneinschubes das aufnehmende Gehäuse leitend kontaktiert.

9. Dreiteiliger Baugruppeneinschub nach Anspruch 8,
**dadurch gekennzeichnet, daß**
der Baugruppeneinschub mechanisch über eine an der Blende (8) angeordnete Schraube (10) mit dem Gehäuse verriegelbar ist.
